(19) **Europäisches Patentamt / European Patent Office / Office européen des brevets**

(11) **EP 1 793 385 A1**

(12) **EUROPEAN PATENT APPLICATION**

(43) Date of publication:
  **06.06.2007 Bulletin 2007/23**

(51) Int Cl.:
  **G11C 11/16** *(2006.01)*

(21) Application number: **06024076.9**

(22) Date of filing: **20.11.2006**

(84) Designated Contracting States:
  **AT BE BG CH CY CZ DE DK EE ES FI FR GB GR HU IE IS IT LI LT LU LV MC NL PL PT RO SE SI SK TR**
  Designated Extension States:
  **AL BA HR MK YU**

(30) Priority: **02.12.2005 JP 2005349790**
  **16.08.2006 JP 2006222046**

(71) Applicant: **SONY CORPORATION**
  **Tokyo (JP)**

(72) Inventors:
  • **Hosomi, Masanori**
    **Tokyo (JP)**
  • **Kano, Hiroshi**
    **Tokyo (JP)**

  • **Higo, Yutaka**
    **Tokyo (JP)**
  • **Bessho, Kazuhiro**
    **Tokyo (JP)**
  • **Yamamoto, Tetsuya**
    **Tokyo (JP)**
  • **Ohmori, Hiroyuki**
    **Tokyo (JP)**
  • **Yamane, Kazutaka**
    **Tokyo (JP)**
  • **Oishi, Yuki**
    **Tokyo (JP)**
  • **Yamagishi, Hajime**
    **Tokyo (JP)**

(74) Representative: **Müller - Hoffmann & Partner Patentanwälte**
  **Innere Wiener Strasse 17**
  **81667 München (DE)**

(54) **Spin transfer magnetic memory**

(57)    A storage element (10) includes a storage layer (17) for holding information by use of a magnetization state of a magnetic material, with a pinned magnetization layer (19) provided on one side of the storage layer (17), with an intermediate layer (16), to form a laminate film, and with the direction of magnetization of the storage layer (17) being changed due to spin injection by passing a current in the lamination direction so as to record information in the storage layer (17), wherein the radius of curvature, R, at end portions of a major axis of a plan-view pattern of at least the storage layer (17), in the laminate film constituting the storage element, satisfies the condition, R ≦ 100 nm.

# FIG.1

EP 1 793 385 A1

**Description**

CROSS REFERENCES TO RELATED APPLICATIONS

The present invention contains subject matter related to Japanese Patent Application JP 2006-222046 filed with the Japanese Patent Office on August 16, 2006, the entire contents of which being incorporated herein by reference.

BACKGROUND OF THE INVENTION

1. Field of the Invention

The present invention relates to a storage element in which the direction of magnetization of a storage layer is changed by passing a current and a memory having the storage elements, which are favorably applicable to nonvolatile memory.

2. Description of the Related Art

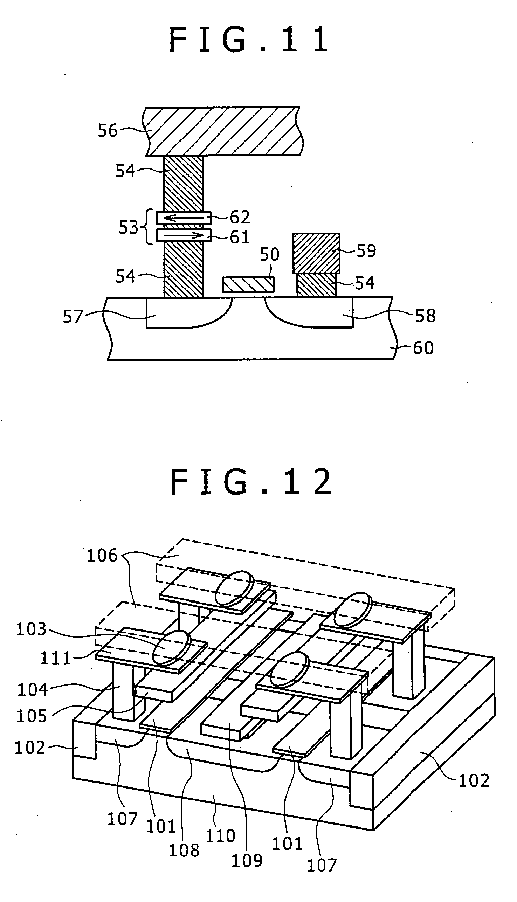

In information apparatuses such as computers, high-operating-speed and high-density DRAMs are widely used as random access memories (RAMs).
However, the DRAMs are volatile memories which loose information when the power supply is turned off and, therefore, nonvolatile memories which do not loose information even upon turning-off of the power supply are desired.
As a candidate for a nonvolatile memory, the magnetic random access memory (MRAM) operative to record information by use of magnetization of a magnetic material has been paid attention to, and development thereof has been progressing (refer to, for example, Nikkei Electronics, 2001.2.12, pp.164 to 171).
The MRAM is a memory in which electric currents are passed through two kinds of address wirings (word lines and bit lines) substantially orthogonally intersecting each other, and the magnetization of a magnetic layer of magnetic storage elements located at intersections between the address wirings is reversed by current-induced magnetic fields generated from the address wirings, thereby recording information.
Besides, reading of the information is achieved by use of the so-called magnetoresistance effect (MR effect) in which resistance varies according to the direction of magnetization of the storage layer in the magnetic recording elements.
Here, a schematic diagram (perspective view) of a general MRAM is shown in FIG. 12.
A drain region 108, a source region 107, and a gate electrode 101 which constitute a selection transistor for selecting a memory cell are formed at a portion, isolated by an element isolation layer 102, of a semiconductor substrate 110 such as a silicon substrate.
In addition, a word line 105 extending in the front-rear direction in the figure is provided on the upper side of the gate electrode 101.
The drain region 108 is formed in common for the selection transistors arranged on the left and right sides in the figure, and a wiring 109 is connected to the drain region 108.
A magnetic storage element 103 having a storage layer of which the direction of magnetization can be reversed is disposed between the word line 105 and a bit line 106 located on the upper side and extending in the left-right direction in the figure. The magnetic storage element 103 is composed, for example, of a magnetic tunnel junction element (MTJ element).
Further, the magnetic storage element 103 is electrically connected to the source region 107 through a bypass line 111 extending in the horizontal direction and a contact layer 104 extending in the vertical direction.
When currents are passed through the word line 105 and the bit line 106, current-induced magnetic fields are applied to the magnetic storage element 103, with the result of reversal of the direction of magnetization of the storage layer in the magnetic storage element 103, whereby information can be recorded.
In a magnetic memory such as an MRAM, for stable holding of the information recorded therein, it may be necessary that the magnetic layer (storage layer) for recording information has a fixed coercive force.
On the other hand, for rewriting the recorded information, it may be necessary to pass currents on a certain level in the address wirings.
However, attendant on the miniaturization of the elements constituting the MRAM, the currents for reversing the magnetization direction tend to increase and, on the other hand, the address wirings are reduced in sectional size, so that it becomes difficult to pass sufficient currents in the address wirings.
In view of this, as a configuration capable of magnetization reversal by smaller currents, a magnetic memory designed to utilize magnetization reversal by spin injection has been attracting attention (refer to, for example, Japanese Patent Laid-open No. 2003-17782).

The magnetization by spin injection means a process in which electrons having undergone spin polarization by passing through a magnetic material are injected into another magnetic material to thereby cause magnetization reversal in the magnetic material.

For example, by a process in which a current is passed in a giant magnetoresistance effect element (GMR element) or a magnetic tunnel junction element (MTJ element) in the direction perpendicular to the film plane of the element, it is possible to reverse the magnetization direction of a magnetic layer at at least a part of the element.

In addition, the magnetization reversal by spin injection is advantageous in that the magnetization reversal can be realized with small currents even when the elements are miniaturized.

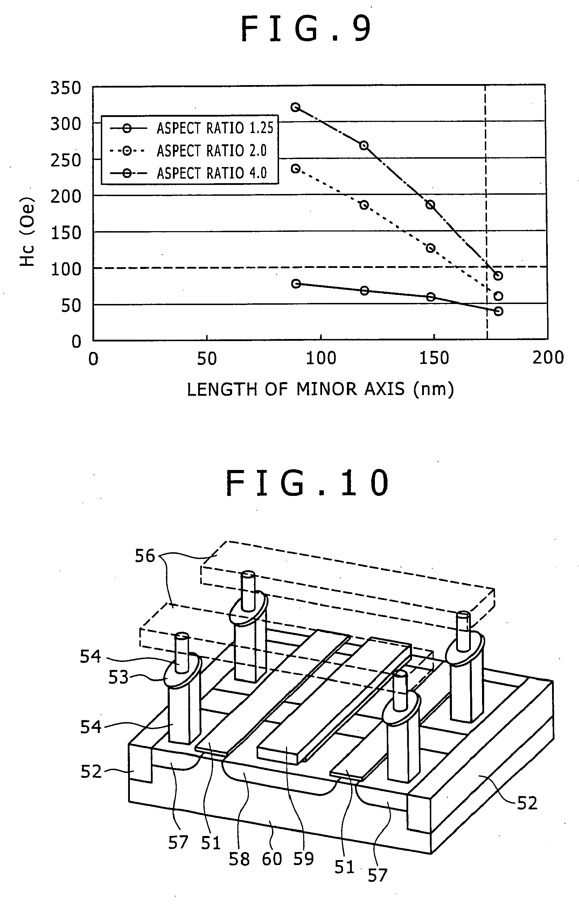

Schematic diagrams of a magnetic memory configured to utilize the magnetization reversal by spin injection as above-mentioned are shown in FIGS. 10 and 11. FIG. 10 is a perspective view and FIG. 11 is a sectional view.

A drain region 58, a source region 57, and a gate electrode 51 which constitute a selection transistor for selecting a memory cell are formed at a portion, isolated by an element isolation layer 52, of a semiconductor substrate 60 such as a silicon substrate. Of these components, the gate electrode 51 functions also as a word line extending in the front-rear direction in FIG. 10.

The drain region 58 is formed in common for selection transistors arranged on the left and right sides in FIG. 10, and a wiring 59 is connected to the drain region 58.

A storage element 53 having a storage layer of which the direction of magnetization can be reversed by spin injection is disposed between the source region 57 and a bit line 56 disposed on the upper side and extending in the left-right direction in FIG. 10.

The storage element 53 is composed, for example, of a magnetic tunnel junction element (MTJ element). Symbols 61 and 62 in the figure denote magnetic layers; of the two magnetic layers 61 and 62, one is a pinned magnetization layer of which the magnetization direction is fixed (pinned), while the other is a free magnetization layer, or storage layer, of which the magnetization direction can be changed.

In addition, the storage element 53 is connected to the bit line 56 and the source region 57 through upper and lower contact layers 54, respectively. This ensures that the magnetization direction of the storage layer in the storage element 53 can be reversed through spin injection by passing a current in the storage element 53.

As compared with a general MRAM shown in FIG. 12, the memory designed to utilize the magnetization reversal by spin injection as above-mentioned has the characteristic feature that the need for a wiring (105 in FIG. 12) for generating a current-induced magnetic field is eliminated and, therefore, the device structure can be simplified.

Also, as compared with the general MRAM that carries out the magnetization reversal by an external magnetic field, by utilizing the magnetization reversal by spin injection, the advantage that current for writing is not increased even if miniaturization of an element proceeds.

SUMMARY OF THE INVENTION

Meanwhile, in the case of the MRAM, the write wirings (word line and bit line) are provided separately from the storage element, and information is written (recorded) by use of the current-induced magnetic field generated by passing currents through the write wirings. Therefore, the currents necessary for writing can be sufficiently passed in the write wirings.

On the other hand, in the memory configured to utilize spin injection, it may be necessary to reverse the magnetization direction of the storage layer by spin injection effected by the current(s) passed in the storage element.

Since the writing (recording) of information is carried out by passing a current or currents directly in the storage element, a memory cell is configured by connecting the storage element to the selection transistor, for selecting the memory cell in which to write the information. In this case, the current flowing in the storage element is limited by the quantity of the current which can be passed through the selection transistor (the saturation current of the selection transistor).

Therefore, it may be necessary to write information with a current smaller than the saturation current of the selection transistor and, therefore, to reduce the current to be passed in the storage element by improving the efficiency of spin injection.

Besides, for enlarging the read signal, it may be necessary to secure a high magnetoresistance variation ratio; for this purpose, a storage element configuration in which intermediate layers in contact with both sides of the storage layer are tunnel insulation layers (tunnel barrier layers) is effective.

In the case where the tunnel insulation layer is thus used as the intermediate layer, the current passed in the storage element is limited, due to the need to prevent dielectric breakdown of the tunnel insulation layer. From this viewpoint also, it may be necessary to suppress the current at the time of spin injection.

Therefore, in the storage element configured to reverse the magnetization direction of the storage layer by spin injection, it may be necessary to improve the spin injection efficiency and thereby to reduce the current needed for writing information.

In a giant magnetoresistance effect element (GMR element) in which a 2 nm-thick CoFeB alloy layer is used as the storage layer and the plan-view pattern is a substantially elliptic shape of 130 nm × 100 nm, for example, the threshold of the write current needed for reversing the magnetization direction of the storage layer by spin injection is +Ic = +0.6 mA as a threshold on the plus (+) side, and -Ic = -0.2 mA as a threshold on the minus (-) side. Besides, the current density in this case is about $6 \times 10^6$ A/cm$^2$ (refer to Onoue et al, Journal of the magnetic society of Japan, Vol. 28, No. 2, p.149, 2004).

In addition, in the case where a CoFe layer generally known as a ferromagnetic layer is used as the material of the storage layer, for example, a current density of about $1 \times 10^7$ A/cm$^2$ may be needed for bringing about magnetization reversal.

With the necessary current density being as above-mentioned, the write current threshold is, for example, about 550 μA where the storage element is 90 nm × 130 nm in size.

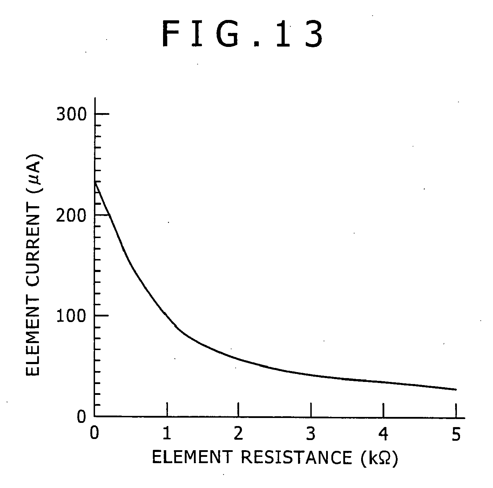

Here, the relationship between the element resistance of a storage element and the element current flowing in the storage element, simulated for the case where general selection transistor and storage element are connected by a SPICE simulator, is shown in FIG. 13.

Taking the magnitude of the read signal into account, a higher element resistance is better. It is seen from FIG. 13, however, that an increase in the element resistance leads to a decrease in the current which can be passed in the storage element.

In addition, considering the case of an element resistance of 2.5 kΩ, which is assumed to be the lower limit in sufficiently securing the read characteristics, it is seen from FIG. 13 that the upper limit of the current permitted to flow through the storage element is about 400 μA, which would make it necessary to reduce the write current threshold further from the above-mentioned value by not less than 30%.

Therefore, it may be demanded to further reduce the write current threshold, for sufficiently securing the read characteristics.

Furthermore, in order to reduce the write current threshold, it is desirable to reduce as much as possible the volume and the saturation magnetization of the storage layer.

However, when the volume and the saturation magnetization of the storage layer are reduced, the thermal stability of the storage elements is lowered, leading to instable operations.

Thus, there is a need to provide a storage element capable of stably holding information, and a memory including the storage elements.

According to one embodiment of the present invention, there is provided a storage element including a storage layer for holding information by use of a magnetization state of a magnetic material, with a pinned magnetization layer provided on one side of the storage layer, with an intermediate layer therebetween, to form a laminate film, and with the direction of magnetization of the storage layer being changed by passing a current in the lamination direction so as thereby to record information in the storage layer, wherein the radius of curvature, R, at end portions of a major axis of a plan-view pattern of at least the storage layer, in the laminate film constituting the storage element, satisfies the condition of R ≦ 100 nm.

According to another embodiment of the present invention, there is provided a memory including: storage elements each having a storage layer for holding information by use of a magnetization state of a magnetic material; and two kinds of wirings intersecting each other, wherein the storage elements each have the configuration of the storage element according to the one embodiment of the present invention, the storage elements are disposed near intersections between the two kinds of wirings and disposed between the two kinds of wirings; and the current in the lamination direction is passed in the storage element by way of the two kinds of wirings.

According to the configuration of the storage element in the one embodiment of the present invention as above-mentioned, the storage element has the storage layer for holding information by use of the magnetization state of the magnetic material, the pinned magnetization layer is provided on one side of the storage layer, with the intermediate layer therebetween, to form the laminate film, and the direction of magnetization of the storage layer is changed by passing a current in the lamination direction so as thereby to record information in the storage layer. Therefore, recording of information can be achieved by passing a current in the lamination direction. In this case, with the current passed in the lamination direction, a spin polarized electron or electrons are injected, whereby the recording by spin injection as above-mentioned is achieved.

In addition, the radius of curvature, R, at end portions of the major axis of the plan-view pattern of at least the storage layer in the laminate film constituting the storage element satisfies the condition of R ≦ 100 nm, whereby the coercive force of the storage layer can be increased. This makes it possible to enhance the stability of the storage layer against heat and the like, and, hence, to stably hold the information recorded in the storage layer.

According to the configuration of the memory in the another embodiment of the present invention, the memory includes the storage elements each having the storage layer for holding information by use of the magnetization state of the magnetic material and the two kinds of wirings intersecting each other, the storage elements each have the configuration of the storage element according to the one embodiment of the present invention, the storage elements are disposed near intersections between the two kinds of wirings and disposed between the two kinds of wirings, and a current in the lamination direction is passed in the storage element by way of the two kinds of wirings. As a result, information can be recorded through spin injection by passing currents in the lamination direction of the storage elements by way of the two kinds of wirings.

In addition, the information recorded in the storage layer in the storage elements can be held stably.

According to the present invention, the storage layer of the storage element is sufficiently stable against heat and the like, so that the storage element is excellent in information holding characteristics.

Therefore, a memory capable of operating stably and high in reliability can be realized.

In addition, since the storage layer has sufficient stability, stable holding of information can be achieved even when miniaturization is contrived by reducing the size of the pattern of the storage element.

By miniaturizing the storage element, it is possible to increase the degree of integration of the memory using the storage elements and to contrive a reduction in the size of the memory and an increase in the storage capacity of the memory.

Furthermore, by the miniaturization of the storage element, it becomes possible to reduce the write current threshold necessary for reversing the magnetization direction of the storage layer, in the case of recording information by spin injection, as above-mentioned. This makes it possible to reduce the current required for recording information, and, therefore, to reduce the power consumption of the memory as a whole and thereby to realize a memory with such a low power consumption as not to be attainable according to the related art.

BRIEF DESCRIPTION OF THE DRAWINGS

FIG. 1 is a schematic configuration diagram (sectional view) of a storage element according to one embodiment of the present invention;

FIG. 2 shows a shape of a plan-view pattern of a storage layer;

FIG. 3 shows a shape of the plan-view pattern of a storage layer;

FIG. 4 shows a shape of the plan-view pattern of a storage layer;

FIGS. 5A to 5F are photographs of storage elements of specimens, as viewed from above;

FIG. 6 is a diagram showing the relationship between the radius of curvature of ends of the major axis of the plan-view pattern and the coercive force Hc of the storage layer;

FIG. 7 is a diagram showing the relationship between the aspect ratio of the plan-view pattern and the coercive force Hc of the storage layer;

FIGS. 8A to 8D show R-H curves of storage elements A to D;

FIG. 9 is a diagram showing the relationship between the length of the minor axis of the plan-view pattern and the coercive force Hc of the storage layer;

FIG. 10 is a schematic configuration diagram (perspective view) of a magnetic memory utilizing magnetization reversal by spin injection;

FIG. 11 is a sectional view of the magnetic memory shown in FIG. 10;

FIG. 12 is a perspective diagram schematically showing the configuration of an MRAM according to the related art; and

FIG. 13 is a diagram showing the relationship between element resistance and element current, in the case where general selection transistor and storage element are connected to each other, based on a SPICE simulator.

DETAILED DESCRIPTION OF THE PREFERRED EMBODIMENTS

Before describing specific embodiments of the present invention, the gist of the invention will first be described below.

The present embodiment is characterized in that information is recorded by reversing the magnetization direction of a storage layer in storage elements by the above-mentioned spin injection. The storage layer is composed of a magnetic material such as a ferromagnetic layer, and is operative to hold information by use of the magnetization state (magnetization direction) of the magnetic material.

The basic operation for reversing the magnetization direction of the magnetic layer by spin injection is to pass a current of not less than a threshold in the storage element composed of a giant magnetoresistance effect element (GMR element) or a tunnel magnetoresistance effect element (MTJ element) in a direction perpendicular to the film plane of the storage element. In this case, the polarity (direction) of the current depends on the magnetization direction to be reversed.

When a current of which the absolute value is lower than the threshold value is passed, the magnetization reversal does not occur.

The threshold of the current needed for reversal of the magnetization direction of the magnetic layer, i.e., the write current threshold Ic, is phenomenalistically represented by the following formula (1) (refer to J. Z. Sun, Phys. Rev. B, Vol. 62, p.570, 2000):

$$Ic = \frac{1}{\eta}\left(\frac{2e}{h}\right)\frac{\alpha}{|cos\,\phi|}\,(a^2 l_m H_k M_s)\left(1+\frac{2\pi M_s}{H_k}+\frac{H}{H_k}\right) \quad \cdots (1)$$

(where $\alpha$ is the damping constant of the storage layer, $H_k$ is the in-plane uniaxial anisotropic magnetic field of the storage layer, $M_s$ is the saturation matnetization of the storage layer, $\eta$ is spin injection coefficient, a is the radius of the storage layer, $l_m$ is the thickness of the storage layer, and H is an externally applied magnetic field.)

In order to reduce the write threshold current Ic, therefore, it suffices to control the various parameters in the formula (1).

On the other hand, the various parameters are limited, from the viewpoint of maintaining the performance as a memory. For example, the term $a^2 l_m H_k M_s$ in the formula (1), known as a term determinative of thermal fluctuation, need to be kept at or above a predetermined value and may not be reduced below the predetermined value, for the purpose of suppressing the dispersion of the write threshold current Ic and for securing the long-term stability of the data written. Therefore, there are lower limits to the size of the storage element and the thickness $l_m$ and saturation magnetization $M_s$, so that the technique of reducing the write current by reducing these parameters encounters a limit at a certain set of conditions.

In the present embodiment, accordingly, the long-term stability of the data written is secured by a contrivance as to the plan-view pattern of the storage layer. This makes it also possible to reduce the write threshold current Ic.

Specifically, in the present embodiment, the storage element has a configuration in which the storage element has a storage layer for holding a magnetization direction (magnetization state) of a magnetic material as information, a pinned magnetization layer with its magnetization direction fixed is provided on one side of the storage layer, with an intermediate layer (insulating layer or non-magnetic conductive layer) therebetween, to form a laminate layer.

In addition, with a current passed in the lamination direction, the magnetization direction of the magnetic material constituting the storage layer is reversed by the above-mentioned spin injection, whereby information is recorded in the storage layer.

In at least the storage layer in the laminate film constituting the storage element, the radius of curvature, R, at end portions of a major axis of the plan-view pattern is set to satisfy the condition of R ≦ 100 nm.

As a result of this configuration, the coercive force Hc of the storage layer is increased, and the stability of the storage layer against heat and the like can be enhanced, so that the information recorded in the storage element can be held (preserved) stably.

Besides, since the storage layer has sufficient stability, the information can be stably held even where the pattern in the storage element is reduced in size for miniaturization of the storage element.

With the storage element thus made finer, the degree of integration of the memory using the storage elements can be increased, leading to a decrease in the size of the memory and an increase in the storage capacity of the memory.

Furthermore, with the storage element miniaturized, it becomes also possible to reduce the write current threshold necessary for reversing the magnetization direction of the storage layer, in the case of recording information by spin injection, as above-mentioned.

Incidentally, as a result of a reduction in the radius of curvature R, the radius a of the storage layer in the above-mentioned term which is determinative of thermal fluctuation is considered to be reduced. On the other hand, however, the in-plane uniaxial anisotropic magnetic field $H_k$ of the storage layer is increased. Therefore, it is possible to maintain the magnitude of the thermal fluctuation-determinative term. Besides, it is seen from the formula (1) above that the write current threshold can be reduced also by an increase in the in-plane uniaxial anisotropic magnetic field $H_k$.

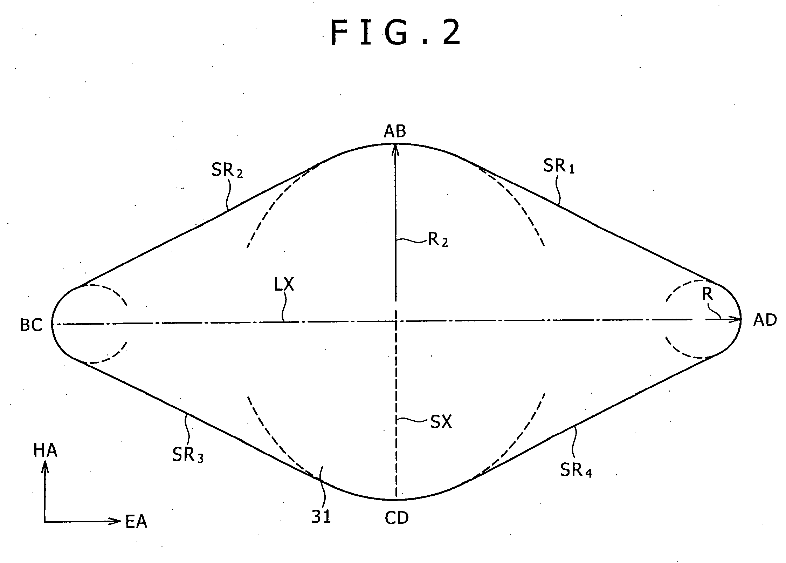

Here, forms of the plan-view pattern of the storage layer in the storage element are shown in FIGS. 2 to 4.

In the form shown in FIG. 2, the plan-view pattern 31 of the storage layer in the storage element is composed of a pseudo-rhombic shape having four sides $SR_1$, $SR_2$, $SR_3$, and $SR_4$. Incidentally, the sides $SR_1$, $SR_2$, $SR_3$, and $SR_4$ connect the intersections BC and AD between the storage layer plan-view pattern 31 and the major axis (longer axis) LX (indicated by dot-dash line) of the pseudo-rhombic shape with the intersections AB and CD between the plan-view pattern 31 and the minor axis (shorter axis) SX (indicated by dot-dash line).

Each of the four sides $SR_1$, $SR_2$, $SR_3$, and $SR_4$ constituting the pseudo-rhombic shape has a straight portion at a central portion thereof.

Besides, in such a plan-view pattern 31, the easy axis of magnetization, EA, of the storage layer is substantially parallel to the major axis LX of the pseudo-rhombic shape, and the hard axis of magnetization, HA, of the storage layer is substantially parallel to the minor axis SX of the pseudo-rhombic shape.

The plan-view pattern 31 is substantially line symmetrical with respect to the major axis LX, and also to the minor axis SX, of the pseudo-rhombic shape.

Further, the plan-view pattern 31 has a curved line shape in outer profile at end portions of the major axis LX (near the intersections AD and BC) and at end portions of the minor axis SX (near the intersections AB and CD), and these cured line shaped portions are smoothly connected to each other through the straight portions of the four sides $SR_1$, $SR_2$, $SR_3$, and $SR_4$.

In addition, the radius of curvature R, at the end portions of the major axis LX is sufficiently small, as compared with the radius of curvature $R_2$, at the end portions of the minor axis SX (R < R2).

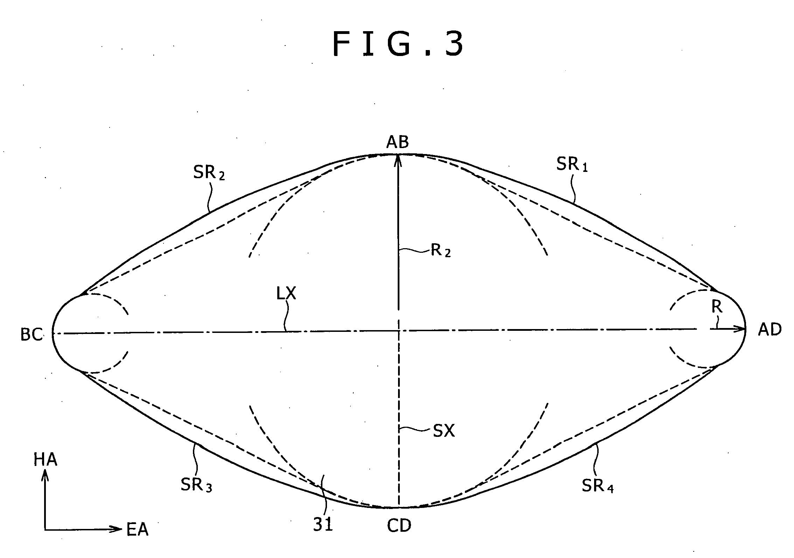

While the plan-view pattern 31 has the pseudo-rhombic shape and the central portions of the four sides $SR_1$, $SR_2$, $SR_3$, and $SR_4$ are straight in FIG. 2, the plan-view shape 31 may be composed of a smooth line as shown in FIG. 3 in which four sides $SR_1$, $SR_2$, $SR_3$, and $SR_4$ constituting a pseudo-rhombic shape each have a central portion curved toward the outside.

In the case where the plan-view pattern 31 has the shape as shown in FIG. 3, the radii of curvature R and R2, at the end portions of the major axis LX (near the intersections AD and BC) and at the end portions of the minor axis SX (near the intersections AB and CD) are equal in size to those in the shape shown in FIG. 2. However, the curved line shaped portions having the radii of curvature, R and R2, in FIG. 3 are narrower than those in the shape shown in FIG. 2.

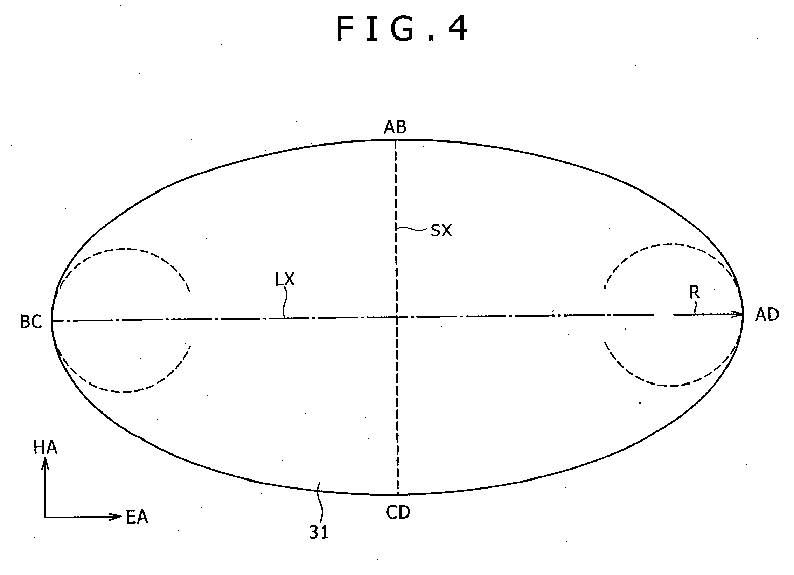

The shape shown in FIG. 4 has been obtained by further swelling the plan-view pattern 31 so as to achieve a change from the pseudo-rhombic shape into a substantially elliptic shape.

Where the plan-view pattern 31 is thus in the substantially elliptic shape, end portions of the major axis LX and the minor axis SX are each in the shape of a gradually curved surface. Therefore, when the substantially elliptic shape is compared with the pseudo-rhombic shape, for an equal major axis LX and an equal minor axis SX, the radii of curvature, R and R2, at the end portions of the major axis LX and the end portions of the minor axis SX are both greater.

In the present embodiment, in any of the cases of the shapes shown in FIGS. 2 to 4, the laminate film is so patterned that the radius of curvature, R, at the end portions of the major axis LX of the plan-view pattern 31 of the storage layer satisfies the condition of R ≦ 100 nm, thereby forming the storage element.

Incidentally, in the present embodiment, the detailed shape of the plan-view pattern of the storage layer is not particularly limited.

However, where the plan-view pattern is set in the substantially elliptic shape as shown in FIG. 4, the ratio of the radius of curvature, R, at the end portions of the major axis LX to the length of the major axis LX becomes comparatively large.

Therefore, where the plan-view pattern is set in the substantially elliptic shape, the length of the major axis LX is set to be comparatively small in such a manner that the radius of curvature, R, satisfies the condition of R ≦ 100 nm.

In addition, if the radius of curvature, R, at the end portions of the major axis LX is greater than half the length of the minor axis SX, the plan-view pattern is more swollen then a substantially elliptic shape to approach a rectangular shape, with the result that the magnetic anisotropy of the storage layer is reduced and the coercive force Hc is reduced.

Preferably, therefore, the radius of curvature, R, at the end portions of the major axis LX and the length W of the minor axis SX satisfy the relationship of R ≦ W/2.

Besides, preferably, the aspect ratio (L/W), which is the ratio of the length L of the major axis to the length W of the minor axis of the plan-view pattern, is set to be not less than 1.5.

If the aspect ratio of the plan-view pattern (the ratio L/W of the length L of the major axis to the length W of the minor axis) is less than 1.5, it is difficult to form regions with a small radius of curvature such as to promise a shape magnetic anisotropy and, therefore, the effect of setting the radius of curvature, R, to be small is reduced.

Incidentally, the upper limit of the aspect ratio (L/W) of the plan-view pattern is not particularly determined from the viewpoint of magnetic anisotropy. It is to be noted, however, that when the aspect ratio (L/W) is increased to or above 4.0, the coercive force Hc comes to be saturated and, therefore, the influence of an increase in the current due to an increase in the element area comes to surpass the effect of the magnetic anisotropy in improving the thermal stability Δ. Therefore, more preferably, the aspect ratio (L/W) of the plan-view pattern is set in the range of 1.5 to 4.0.

When the length L of the major axis LX of the plan-view pattern becomes very large in relation to the radius of curvature, R, at the end portions of the major axis LX, it becomes difficult to form the pattern, and the shape of the plan-view pattern approaches a rhombus or an elongate shape. Where the shape of the plan-view pattern is a rhombus or an elongate shape, a magnetic domain or a vortex of magnetization is liable to be generated in the end portions of the major axis LX, with result that an intermediate resistance value between two values corresponding to a high-resistance state and a low-resistance state may be obtained, or an imperfect magnetization reversal may be caused.

In such a case, the conditions for the current and the like for recording information by reversal of the magnetization of the storage layer are severe.

Preferably, therefore, the radius of curvature, R, and the length L of the major axis are set to satisfy the relationship of L/24 ≦ R.

In view of the fact that a certain level of current density is necessary for reversal of the magnetization of the storage layer and that the current which can be passed in the storage element has an upper limit as above-mentioned, it is more desirable that the area of the plan-view pattern is smaller.

On the other hand, it is also necessary to secure the volume and the magnetic anisotropy of the storage layer, from the viewpoint of securing the thermal stability $\Delta$.

In order to attain both of these contradictory demands, i.e., the reduction of the area of the plan-view pattern and the securing of a value of thermal stability $\Delta$ through enhancement of magnetic isotropy, it suffices to reduce the length W of the minor axis of the plan-view pattern. Preferably, the length W of the minor axis of the plan-view pattern is set to be not more than 175 nm.

Incidentally, as for the lower limit of the length W of the minor axis of the plan-view pattern, limitations on a manufacturing technology basis are greater than limitations on a characteristics basis. When evaluation experiments of magnetic isotropy and $\Delta$ value were conducted for a superfine storage element produced under special conditions, it was found that satisfactory magnetization may not be obtained when the length W of the minor axis is set to about 20 nm. Therefore, it is desirable to set the length W of the minor axis of the plan-view pattern to be not less than 20 nm. However, there is the possibility that magnetization might be obtained even with a further reduction in the length W of the minor axis, depending on the development of magnetic materials in the future.

The other configurations of the storage element may be the same as or equivalent to those of the storage elements for recording information by spin injection according to the related art.

Ordinarily, the storage layer is composed mainly of a ferromagnetic material or materials such as Co, Fe, Ni, and Gd. Specifically, one or more layers each formed of an alloy of at least two of these materials are laminated, to form the storage layer.

To each of the ferromagnetic layers, an alloy element or elements are added for control of magnetic properties, such as saturation magnetization, and crystal structure (crystalline, microcrystalline structure, amorphous structure). For example, there may be used those materials in which a CoFe alloy, a CoFeB alloy, an Fe alloy or an NiFe alloy is used as a main constituent, and one or more of magnetic elements such as Gd, etc. and other elements such as B, C, N, Si, P, Al, Ta, Mo, Cr, Nb, Cu, Zr, W, V, Hf, Gd, Mn, and Pd are added to the main constituent. Besides, for example, amorphous materials obtained by adding at least one element selected from the group consisting of Zr, Hf, Nb, Ta, and Ti to Co, and Heusler materials such as CoMnSi, CoMnAl, and CoCrFeAl, etc. may also be used.

In addition, the storage layer may be configured also by directly laminating a plurality of ferromagnetic layers different in materials or in composition ranges. Besides, ferromagnetic and soft magnetic layers may be laminated; further, a plurality of ferromagnetic layers may be laminated, with a soft magnetic layer therebetween. In the cases of such laminations, also, the effects of the present invention can be obtained.

In addition, where a magnetic tunnel junction (MTJ) element is composed by use of a tunnel insulation layer as a non-magnetic intermediate layer between the storage layer and a pinned magnetization layer, magnetoresistance variation ratio (MR ratio) can be enhanced and read signal magnitude can be enhanced, as compared with the case where a giant magnetoresistance effect (GMR) element is composed by use of a non-magnetic conductive layer.

Examples of the materials which can be used for forming the tunnel insulation layer include such oxides as aluminum oxide ($AlO_x$) and magnesium oxide (MgO).

Particularly where magnesium oxide (MgO) is used as the material of the tunnel insulation layer, magnetoresistance variation ratio (MR ratio) can be enhanced, more than in the case of using aluminum oxide, which has hitherto been used generally.

In general, spin injection efficiency depends on the MR ratio, and as the MR ratio is higher, the spin injection efficiency is enhanced more and the magnetization reversing current density can be reduced more.

Therefore, by using magnesium oxide as the material of the tunnel insulation layer provided as an intermediate layer, the write threshold current in writing (recording) by spin injection can be reduced, so that information can be written (recorded) with less current. In addition, the read signal intensity can be enhanced.

By this it is possible to secure the MR ratio (TMR ratio), thereby to reduce the write threshold current in writing by spin injection, and to write (record) information with less current. Besides, the read signal intensity can be enhanced.

The pinned magnetization layer has its magnetization direction fixed by being composed of a ferromagnetic layer or by utilizing antiferromagnetic coupling between an antiferromagnetic layer and a ferromagnetic layer.

In addition, the pinned magnetization layer is composed of a single ferromagnetic layer, or has a laminate ferri structure in which a plurality of ferromagnetic layer are laminated, with a non-magnetic layer therebetween. Where the pinned magnetization layer has the laminate ferri structure, the sensitivity of the pinned magnetization layer to external magnetic fields can be lowered, so that it is possible to suppress unnecessary variations in the magnetization of the pinned magnetization layer due to external magnetic fields, and to make the storage element operate stably. Furthermore, it is possible to regulate the film thickness of each of the ferromagnetic layers, and to suppress leakage of magnetic field from the pinned magnetization layer.

Examples of the material usable for the ferromagnetic layers constituting the pinned magnetization layer in the laminate ferri structure include Co, CoFe, and CoFeB. Examples of the material usable for the non-magnetic layer include Ru, Re, Ir, and Os.

Examples of the material for the antiferromagnetic layer include such magnetic materials as FeMn alloy, PtMn alloy, PtCrMn alloy, NiMn alloy, IrMn alloy, and NiO, $Fe_2O_3$.

Besides, it is possible, by adding a non-magnetic element such as Ag, Cu, Au, Al, Si, Bi, Ta, B, C, O, N, Pd, Pt, Zr, Hf, Ir, W, Mo, Nb, etc. to the magnetic material, to control magnetic properties and other properties such as crystal structure, crystallinity, substance stability, etc.

In addition, as the film configuration of the storage element, a configuration in which the storage layer is disposed on the upper side of the pinned magnetization layer and a configuration in which the storage layer is disposed on the lower side of the pinned magnetization layer can be used without any problem.

Incidentally, as for the method of reading the information recorded in the storage layer of the storage element, a magnetic layer serving as a reference for information may be provided on one side of the storage layer of the storage element, with a thin insulation layer therebetween, and the information may be read by use of a ferromagnetic tunnel current flowing through the insulation layer or may be read by use of the magnetoresistance effect.

Now, specific embodiments of the present invention will be described below.

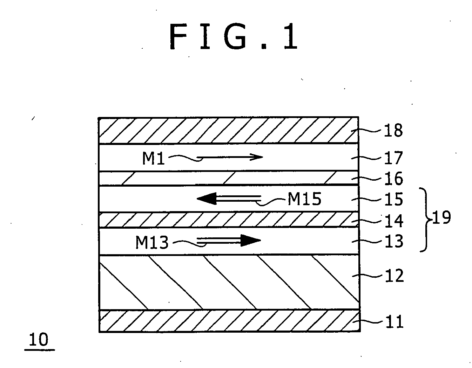

FIG. 1 shows a schematic configuration diagram (sectional view) of a storage element as one embodiment of the present invention.

The storage element 10 includes an under layer 11, an antiferromagnetic layer 12, a ferromagnetic layer 13, a non-magnetic layer 14, a ferromagnetic layer 15, a tunnel insulation layer 16, a storage layer 17, and a cap layer (protective layer) 18 laminated in this order from the lower side.

Incidentally, the layers 11 to 18 thus laminated have been patterned into substantially the same plan-view pattern, though not shown in the figure.

The storage layer 17 is composed of a magnetic material, and is so configured to be able to hold information in terms of magnetization state (the direction of magnetization M1 of the storage layer 17).

The ferromagnetic layer 13, the non-magnetic layer 14 and the ferromagnetic layer 15 constitute a pinned (fixed) magnetization layer 19 having a laminate ferri structure. The direction of magnetization M15 of the ferromagnetic layer 15 is leftward, i.e., is anti-parallel to the direction of magnetization M13 of the ferromagnetic layer 13.

In addition, the ferromagnetic layer 15 serves as a reference of magnetization direction for the storage layer 17 and, therefore, it is referred to also as reference layer.

The material for the ferromagnetic layers 13 and 15 in the pinned magnetization layer 19 is not particularly limited, and alloy materials composed of one or more of iron, nickel, and cobalt, for example, a CoFe alloy can be used. Furthermore, the alloy material may contain a transition metal, such as Nb and Zr, and/or a light element, such as B.

For example, amorphous CoFeB obtained by adding boron (B) to a CoFe alloy in an amount of 20 to 30 atom % can also be used.

Besides, by use of CoFeB particularly for the ferromagnetic layer (reference layer) 15, in contact with the tunnel layer 16, of the pinned magnetization layer 19, it is possible to enhance the spin polarization ratio and to enhance the spin injection efficiency of the storage element 10. This makes it possible to further reduce the current necessary for reversing the direction of magnetization M1 of the storage layer 17.

Examples of the material usable for the tunnel insulation layer 16 include insulating materials, for example, oxides of Al, Mg, Hf, Si, etc., other oxides, nitrides, and so on.

Particularly where magnesium oxide (MgO) is used as the material of the tunnel insulation layer 16, a high magnetoresistance variation ratio (MR ratio) can be obtained, as above-mentioned.

Reversal of the direction of magnetization of the storage layer 17 by spin injection can be carried out by passing a current between the under layer 11 and the cap layer 18.

When a current is passed in the direction of from the cap layer 18 toward the under layer 11, i.e., in the direction of from the storage layer 17 toward the ferromagnetic layer (reference layer) 15, polarized electrons are injected from the ferromagnetic layer (reference layer) 15 into the storage layer 17, and the magnetization direction of the storage layer 17 is made to be parallel to the magnetization direction of the reference layer 15.

On the other hand, when a current is passed in the direction of from the under layer 11 toward the cap layer 18, i.e., in the direction of from the reference layer 15 toward the storage layer 17, polarized electrons are injected from the storage layer 17 into the reference layer 15, and the magnetization direction of the storage layer 17 is made to be anti-parallel to the magnetization direction of the reference layer 15.

In this manner, the information to be recorded can be selected according to the direction in which the current is passed.

When the magnetization direction of the ferromagnetic layer (reference layer) 15 and the magnetization direction of the storage layer 17 are parallel, the resistance to the current flowing through the tunnel insulation layer 16 is low; on the other hand, when the two magnetization directions are anti-parallel, the resistance to the current flowing through the tunnel insulation layer 16 is high. By use of this difference, the information recorded in the storage layer 17 can be read from the resistance value.

Incidentally, the current passed at the time of reading is set to be smaller than the reversing current so that reversal of the magnetization of the storage layer 17 would not be generated by spin injection at this time.

In the present embodiment, particularly, the plan-view pattern of the laminate film of the storage element 10 including the storage layer 17 is configured to satisfy the above-mentioned conditions according to the present embodiment, i.e., the condition of R ≦ 100 nm, where R is the radius of curvature at end portions of the major axis LX (see FIGS. 2 to 4).

This makes it possible to enhance the coercive force Hc of the storage layer 17 and, hence, to enhance the stability of the storage layer 17 against heat and the like, as above-mentioned.

The storage element 10 in this embodiment can be manufactured by a method in which the layers ranging from the under layer 11 to the cap layer 18 are successively formed in a vacuum apparatus, and then the pattern of the storage element 10 is formed by etching or the like processing.

In addition, by use of the storage elements 10 according to this embodiment, a memory having an equivalent configuration to that of the memory shown in FIG. 10 can be composed.

Specifically, the storage elements 10 are disposed near the intersections between two kinds of address wirings to compose the memory, and currents in the vertical direction (lamination direction) are passed in some of the storage elements 10 by way of the two kinds of address wirings to reverse the direction of magnetization of the storage layer 17 by spin injection, whereby information can be recorded in the storage elements 10.

According to the configuration of the storage element 10 in this embodiment as above, the plan-view pattern of the laminate film in the storage element 10 including the storage layer 17 satisfies the condition of R ≦ 100 nm, where R is the radius of curvature at the end portions of the major axis LX of the pattern, whereby the coercive force Hc of the storage layer 17 can be made to be high.

This makes it possible to enhance the stability of the storage layer 17 against heat and the like, and to stably hold the information recorded in the storage layer 17.

In other words, it is possible to configure a storage element 10 excellent in information preserving characteristic.

Therefore, by configuring a memory using the storage elements 10 according to this embodiment, it is possible to realize a memory which operates stably and is high in reliability.

Besides, according to the present embodiment, the storage layer 17 has sufficient stability, so that information can be stably held even when the pattern of the storage element 10 is reduced for contriving miniaturization.

The miniaturization of the storage element 10 increases the degree of integration of the memory including the storage elements 10, whereby it is possible to achieve a reduction in the size of the memory and an increase in the storage capacity of the memory.

Furthermore, the miniaturization of the storage element 10 makes it also possible to reduce the write current threshold Ic necessary for reversing the direction of magnetization M1 of the storage layer 17 in the case of recording information by spin injection.

This makes it possible to reduce the amount of the current necessary for information recording and, therefore, to lower the power consumption of the memory as a whole and to realize a memory with such a low power consumption as not to be attainable according to the

related art.

Incidentally, while the case where the layers 11 to 18 in the laminate film (inclusive of the storage layer 17) constituting the storage element 10 are formed in the same plan-view pattern has been described in the present embodiment as above-described, in the present invention the plan-view pattern(s) of the other layers than the storage layer may not necessarily satisfy the above-mentioned condition, inasmuch as the plan-view pattern of at least the storage layer satisfies the above-mentioned condition.

For example, in relation to the storage element 10 shown in FIG. 1, there may be contemplated a configuration in which the under layer 11 and the antiferromagnetic layer 12 are formed in a plan-view pattern larger than that of the other layers 13 to 18 on the upper side thereof, a configuration in which the cap layer 18 is formed in a plan-view pattern different from that of the storage layer 17, and the like.

(Examples)

Here, concerning the configuration of the storage element in the present invention, how the characteristics of the storage element will be when the dimensions, composition and the like of the storage layer are specifically set was investigated.

Incidentally, in practice, the memory includes not only the storage elements but also semiconductor circuits for switching, etc., as shown in FIG. 10; here, however, the investigation was conducted by use of a wafer on which the storage elements had been formed, for the purpose of examining the magnetoresistance characteristics of the storage layer.

<Experiment 1>

First, a 2 $\mu$m-thick thermal oxide film is formed on a 0.575 mm-thick silicon substrate, and a storage element the same as the storage element 10 shown in FIG. 1 was formed.

Specifically, in the storage element 10 configured as shown in FIG. 1, the under layer 11 was selected to be a 3 nm-thick Ta film, the antiferromagnetic layer 12 to be a 20 nm-thick PtMn film, the ferromagnetic layers 13 and 15 constituting the pinned magnetization layer 19 to each be a 2 nm-thick CoFe film, the non-magnetic layer 14 constituting the pinned magnetization layer 19 of the laminate ferri structure to be a 0.8 nm-thick Ru film, the tunnel insulation layer 16 to be an aluminum oxide film obtained by oxidizing an Al film with a thickness of 0.5 nm, the storage layer 17 to be a 3 nm-thick $Co_{72}Fe_8B_{20}$ film, and the cap layer 18 to be a 5 nm-thick Ta film, and these layers were formed, with a 100 nm-thick Cu film (not shown) (to be a word line which will be described later) being provided between the under layer 11 and the antiferromagnetic layer 12.

In other words, the storage element 10 was produced in which the materials and film thicknesses of the layers were determined as given in the following configuration (Film Configuration 1).

Film Configuration 1:

Ta(3 nm)/Cu(100 nm)/PtMn(20 nm)/CoFe(2 nm)/Ru(0.8 nm) /CoFe (2 nm)/Al (0.5 nm) -$O_x$/$Co_{72}Fe_8B_{20}$(3 nm) /Ta (5 nm)

Incidentally, in the just-mentioned film configuration, the composition of PtMn for which the alloy composition is not given was set to be $Pt_{50}Mn_{50}$ (atm %).

The tunnel insulation layer 16 composed of an aluminum oxide (Al-$O_x$) film was formed by depositing a metallic Al film in a thickness of 0.5 nm by a DC sputtering method, and the metallic Al layer was oxidized by a natural oxidation method while using an oxygen/argon flow rate ratio of 1:1. The oxidization time was ten minutes.

Further, after the formation of the layers for constituting the storage element 10, a heat treatment was conducted in a heat treatment furnace in a magnetic field under the conditions of 10 kOe, 270°C and for four hours, as a normalizing heat treatment of the PtMn film constituting the antiferromagnetic layer 12.

Next, the word line portion was masked by photolithography, and selective etching using an Ar plasma was applied to the portions, other than the word line portion, of the laminate film, to form a word line (lower electrode). In this case, the portions other than the word line portion were etched down to a depth of 5 nm of the substrate.

Thereafter, a mask for the pattern of the storage element 10 was formed by an electron beam drawing apparatus, and selective etching was applied to the laminate film, to form the storage element 10. The portions other than the storage element 10 portion were etched down to a position immediately above the Cu layer of the word line.

Next, the portions other than the storage element 10 portion were insulated with an about 100 nm-thick $Al_2O_3$ film formed by sputtering.

Thereafter, by use of photolithography, a bit wire to be an upper electrode and a measurement pad were formed, to produce a storage element sample, as Sample 1 of storage element.

Then, by the above-described manufacturing method, samples of storage element 10 differing in the radius of curvature, R, at end portions of the major axis of the plan-view pattern of the storage element 10 were manufactured.

Six values of 31 nm, 47 nm, 53 nm, 90 nm, 120 nm, and 170 nm were selected for the radius of curvature, R, at the end portions of the major axis.

Besides, in the plan-view pattern of the samples, the length of the major axis was set to be 400 nm, and the length of the minor axis to be 150 nm.

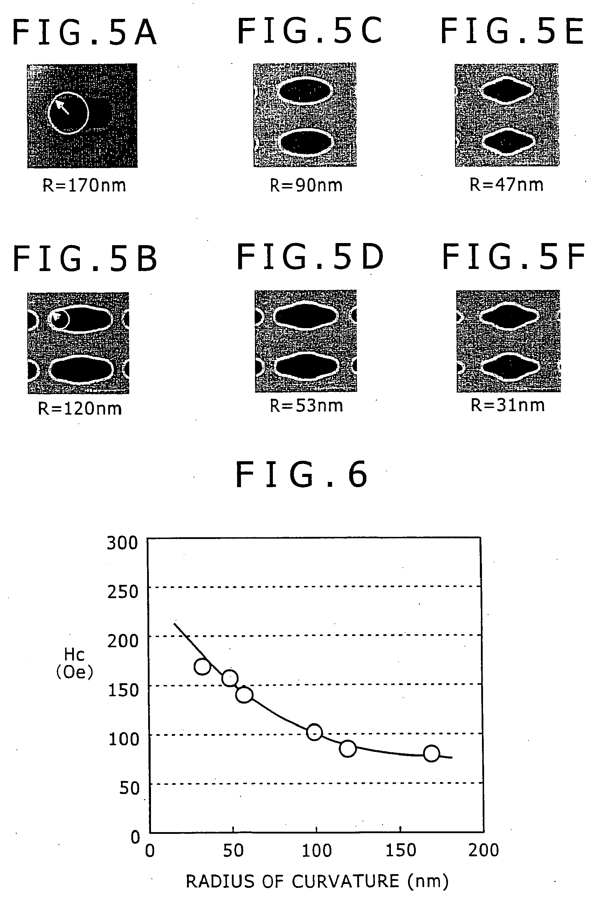

The microphotographs, from above, of the samples of storage element 10 are shown in FIGS. 5A to 5F.

Where the radius of curvature, R, was set to be 170 nm, the radius of curvature was so large that the plan-view pattern resembled a rectangular shape.

Where the radius of curvature, R, was set to be 90 nm, the plan-view pattern resembled a substantially elliptic shape.

Further, it is seen that as the radius of curvature, R, is reduced, the portions near the ends of the major axis become increasingly constricted in shape.

(Measurement of Coercive Force of Storage Layer)

For each of the samples of storage element 10, the coercive force Hc of the storage layer 17 was measured.

The accurate dimensions and shapes of the plan-view pattern of the storage elements 10 were determined based on the microphotographs, from above, of the storage elements 10 shown in FIGS. 5A to 5F. From the dimensions and shapes and the magnetic properties (saturation magnetic flux density, etc.) of the material of the storage layer 17, the coercive force Hc of the storage layer 17 was estimated by computation.

The relationship between the radius of curvature, R, at end portions of the major axis of the pattern of the storage element 10 and the coercive force Hc of the storage layer 17, obtained as a result of the foregoing, is shown in FIG. 6.

It is seen from FIG. 6 that a reduction in the radius of curvature, R, leads to an increase in the coercive force Hc. In addition, it is seen that the increase of the coercive force Hc becomes larger from the vicinity of a radius of curvature R = 100 nm.

Therefore, it is understood that when the radius of curvature, R, is set in the range of R $\leqq$ 100 nm, it is possible to enhance the coercive force Hc of the storage layer 17 and thereby to enhance the stability of the storage layer 17 against heat and the like.

<Experiment 2>

By the same manufacturing method as in Experiment 1, samples of storage element 10 differing in the radius of curvature, R, at end portions of the major axis of the plan-view pattern of the storage element 10 and in the aspect ratio of the pattern were produced.

For values of 31 nm, 47 nm, 53 nm, and 90 nm were selected as the radius of curvature, R, at the end portions of the major axis.

Besides, in the plan-view patterns of the samples, the minor axis length W was set to be 120 nm, while six values of 145 nm, 190 nm, 240 nm, 430 nm, and 525 nm were selected for the major axis length L, whereby the aspect ratio (L/W) was varied as 1.2, 1.6, 2.0, 2.8, 3.6, and 4.4.

For each of these samples of storage element 10, the coercive force Hc of the storage layer 17 was measured.

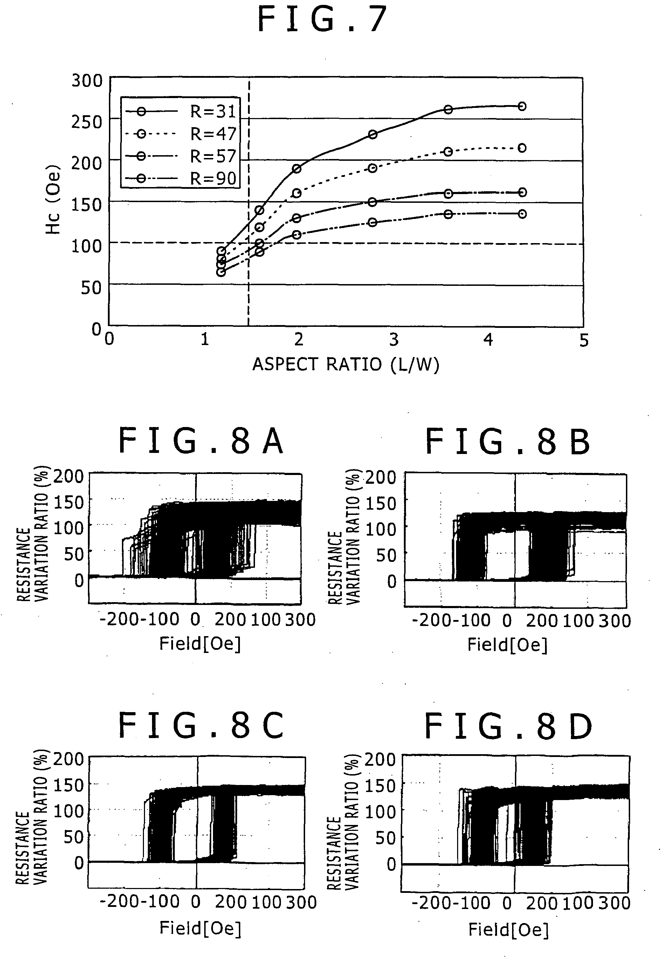

The relationship between the aspect ratio (major axis length L/minor axis length W) of the pattern of the storage element 10 and the coercive force Hc of the storage layer 17, obtained as a result of the measurement, is shown in FIG. 7.

Since the samples in Experiment 2 satisfy the condition of W = 120 nm, it is desirable to set the radius of curvature, R, in such a range as to satisfy the condition of R $\leqq$ W/2 = 60 nm.

It is seen from FIG. 7 that the coercive force Hc is greater in the cases where the values of the radius of curvature, R, are respectively 31 nm, 47 nm, and 53 nm, which satisfy the just-mentioned condition, than in the case where R = 90 nm.

In addition, it is seen from FIG. 7 that where the aspect ratio is not less than 1.5, it is possible to enhance the coercive force Hc of the storage layer 17 and thereby to enhance the stability of the storage layer 17 against heat and the like.

Incidentally, it is also seen from FIG. 7 that when the aspect ratio reaches or exceeds 4.0, the coercive force Hc of the storage layer 17 is saturated and, hence, little increased further.

<Experiment 3>

By the same manufacturing method in Experiment 1, samples of storage element 10 differing in the radius of curvature, R, at end portions of the major axis of the plan-view pattern of the storage element 10 were produced.

Four values of 15 nm, 22 nm, 31 nm, and 53 nm were selected for the radius of curvature, R, at the end portions of the major axis.

Besides, in the plan-view patterns of the samples, the major axis length was set to be 400 nm, and the minor axis length was set to be 150 nm.

For each of the samples of storage element 10, the continuous variation of the resistance variation with an external magnetic field was determined, to obtain R-H curves.

For each of the samples, 200 memory cell elements were subjected to the measurement, the results being shown in FIGS. 8A to 8D. In each of FIGS. 8A to 8D, the R-H curves of the 200 elements are shown in a superposed state, the axis of ordinates represents the resistance variation ratio with the resistance value in a low-resistance state taken as a reference, and the axis of abscissas represents the magnitude of the external magnetic field. FIG. 8A shows the case where R = 15 nm, FIG. 8B shows the case where R = 22 nm, FIG. 8C shows the case where R = 31 nm, and FIG. 8D shows the case where R = 53 nm.

It is seen from FIG. 8A that where R = 15 nm, i.e., where the radius of curvature, R, is less than 1/24 times the major axis length L, distortions are generated in the R-H curves, and cases of intermediate resistance values may exist, other than a high-resistance state and a low-resistance state.

In such a case, the conditions for current or the like necessary for information recording by reversal of magnetization of the storage layer 17 are severe.

It is seen from FIGS. 8B to 8D that in the other cases where the radius of curvature, R, is not less than 1/24 times the major axis length L, favorable R-H curves are obtained.

Therefore, it is understood that stable R-H curves can be obtained by setting the radius of curvature, R, and the major axis length L in such ranges as to satisfy the relationship of $L/24 \leqq R$.

<Experiment 4>

By the same manufacturing method as in Experiment 1, samples of storage element 10 differing in the major axis length L and the minor axis length W of the plan-view pattern in the storage element 10 were produced.

The storage elements 10 were patterned by a method in which four values of 90 nm, 120 nm, 150 nm, and 180 nm were selected for the minor axis length W of the plan-view pattern of the storage element 10, while the major axis length L in each case was so adjusted as to obtain three aspect ratio values of 1.25, 2.0, and 4.0. Namely, a total of 12 kinds of plan-view patterns were prepared.

Incidentally, in the plan-view patterns of these samples, the radius of curvature, R, at end portions of the major axis was fixed at 31 nm.

For each of these samples of storage element 10, the coercive force Hc of the storage layer 17 was measured.

The measurement results are shown in FIG. 9. In FIG. 9, the axis of abscissas represents the length W of the minor axis of the plan-view pattern, while the axis of ordinates represents the coercive force Hc, and the values obtained in the cases with the same aspect ratio are connected by a line.

As shown in FIG. 7, the value of the coercive force Hc becomes saturated when the aspect ratio reaches or exceeds 4.0. Accordingly, it is seen from FIG. 9 that, in order to secure a value of coercive force Hc of not less than 100 Oe, it is necessary for the minor axis length to be not more than the value of 175 nm, which is the value where the coercive force Hc = 100 Oe under the condition of an aspect ratio of 4.0.

The present invention is not limited to the above-described embodiments, and other various configurations are possible within the scope of the gist of the invention.

**Claims**

1. A storage element comprising a storage layer for holding information by use of a magnetization state of a magnetic material,
   with a pinned magnetization layer provided on one side of said storage layer, with an intermediate layer, to form a laminate film, and
   with the direction of magnetization of said storage layer being changed by passing a current in the lamination direction so as to record information in said storage layer, wherein
   the radius of curvature, R, at end portions of a major axis of a plan-view pattern of at least said storage layer, in said laminate film constituting said storage element, satisfies the condition:

   $R \leqq 100$ nm.

2. The storage element as set forth in claim 1, wherein said intermediate layer includes magnesium oxide.

3. The storage element as set forth in claim 1, wherein said radius of curvature, R, and the length W of a minor axis of said plan-view pattern satisfy the relationship of $R \leqq W/2$.

4. The storage element as set forth in claim 1, wherein said plan-view pattern has an aspect ratio, which is the ratio of the length of said major axis to the length of a minor axis, of not less than 1.5.

5. The storage element as set forth in claim 1, wherein said radius of curvature, R, and the length L of said major axis of said plan-view pattern satisfy the relationship of $L/24 \leqq R$.

6. The storage element as set forth in claim 1, wherein the length of a minor axis of said plan-view pattern is not more than 175 nm.

7. A memory comprising:

   storage elements each having a storage layer for holding information by use of a magnetization state of a magnetic material; and

two kinds of wirings intersecting each other, wherein
said storage elements each have a configuration in which a pinned magnetization layer is provided on one side of said storage layer, with an intermediate layer, to form a laminate film, the direction of magnetization of said storage layer is changed by passing a current in the lamination direction so as to record information in said storage layer, and the radius of curvature, R, at end portions of a major axis of a plan-view pattern of at least said storage layer in said laminate film constituting said storage element satisfies the condition of $R \leq 100$ nm; said storage elements are disposed near intersections between said two kinds of wirings and disposed between said two kinds of wirings; and
said current in said lamination direction is passed in said storage element by way of said two kinds of wirings.

8. The memory as set forth in claim 7, wherein said intermediate layer in said storage element includes magnesium oxide.

9. The memory as set forth in claim 7, wherein said storage elements are each so configured that said radius of curvature, R, and the length W of a minor axis of said plan-view pattern satisfy the relationship of $R \leq W/2$.

10. The memory as set forth in claim 7, wherein said plan-view pattern in said storage element has an aspect ratio, which is the ratio of the length of said major axis to the length of said minor axis, of not less than 1.5.

11. The memory as set forth in claim 7, wherein said storage elements are each so configured that said radius of curvature, R, and the length L of said major axis of said plan-view pattern satisfy the relationship of $L/24 \leq R$.

12. The memory as set forth in claim 7, wherein the length of a minor axis of said plan-view pattern in said storage element is not more than 175 nm.

# FIG.1

| | |
|---|---|
| | ~18 |
| M1 → | ~17 |
| | ~16 |
| ← M15 | ~15 |
| | ~14 |
| M13 ⇒ → | ~13 |
| | ~12 |
| | ~11 |

19

10

# FIG.2

EP 1 793 385 A1

# FIG.3

EP 1 793 385 A1

# FIG.4

EP 1 793 385 A1

# FIG.5A

R=170nm

# FIG.5C

R=90nm

# FIG.5E

R=47nm

# FIG.5B

R=120nm

# FIG.5D

R=53nm

# FIG.5F

R=31nm

# FIG.6

# F I G . 7

# F I G . 8 A

# F I G . 8 B

# F I G . 8 C

# F I G . 8 D

# FIG.9

# FIG.10

# FIG.11

56
54
53 { 62
61
59
54
50
54
57
58
60

# FIG.12

106
103
111
104
105
102
107 101
108 110
109 101
107
102
102

# FIG.13

**European Patent Office**

**EUROPEAN SEARCH REPORT**

Application Number

EP 06 02 4076

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/057992 A1 (YAGAMI KOJIRO [JP]) 17 March 2005 (2005-03-17) * paragraph [0003] - paragraph [0009] * * paragraph [0025] - paragraph [0031] * * paragraph [0035] * * paragraph [0039] - paragraph [0041] * * paragraph [0045] * * paragraph [0056] * | 1,4-7, 10-12 | INV. G11C11/16 |
| X | US 6 888 742 B1 (NGUYEN PAUL P [US] ET AL) 3 May 2005 (2005-05-03) * column 8, line 25 - line 33 * * column 9, line 62 - column 10, line 11; figure 3 * | 1-12 | |
| X | EP 1 349 184 A1 (TOKYO SHIBAURA ELECTRIC CO [JP]) 1 October 2003 (2003-10-01) * paragraph [0048] - paragraph [0052] * * paragraph [0060] - paragraph [0061]; figure 4 * | 1,7 | |

TECHNICAL FIELDS SEARCHED (IPC)

G11C

The present search report has been drawn up for all claims

| Place of search | Date of completion of the search | Examiner |
|---|---|---|
| Munich | 28 February 2007 | Harms, Juergen |

**ANNEX TO THE EUROPEAN SEARCH REPORT
ON EUROPEAN PATENT APPLICATION NO.**

EP 06 02 4076

This annex lists the patent family members relating to the patent documents cited in the above-mentioned European search report.
The members are as contained in the European Patent Office EDP file on
The European Patent Office is in no way liable for these particulars which are merely given for the purpose of information.

28-02-2007

| Patent document cited in search report | | Publication date | Patent family member(s) | | Publication date |
|---|---|---|---|---|---|
| US 2005057992 | A1 | 17-03-2005 | FR 2860645 A1 | | 08-04-2005 |
| | | | JP 2005093488 A | | 07-04-2005 |
| | | | KR 20050027008 A | | 17-03-2005 |
| US 6888742 | B1 | 03-05-2005 | NONE | | |
| EP 1349184 | A1 | 01-10-2003 | CN 1448917 A | | 15-10-2003 |
| | | | DE 60300157 D1 | | 23-12-2004 |
| | | | DE 60300157 T2 | | 10-11-2005 |
| | | | TW 595025 B | | 21-06-2004 |

EPO FORM P0459

For more details about this annex : see Official Journal of the European Patent Office, No. 12/82

# EP 1 793 385 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006222046 A

- JP 2003017782 A

### Non-patent literature cited in the description

- *Nikkei Electronics,* 12 February 2001, 164-171

- **ONOUE et al.** *Journal of the magnetic society of Japan,* 2004, vol. 28 (2), 149
- **J. Z. SUN.** *Phys. Rev. B,* 2000, vol. 62, 570